(19) Europäisches Patentamt
European Patent Office
Office européen des brevets

(11) **EP 0 833 180 A2**

(12) **EUROPÄISCHE PATENTANMELDUNG**

(43) Veröffentlichungstag:
01.04.1998 Patentblatt 1998/14

(51) Int. Cl.⁶: **G02B 17/08**, G03F 7/20

(21) Anmeldenummer: 97115480.2

(22) Anmeldetag: 06.09.1997

(84) Benannte Vertragsstaaten:
AT BE CH DE DK ES FI FR GB GR IE IT LI LU MC NL PT SE
Benannte Erstreckungsstaaten:
AL LT LV RO SI

(30) Priorität: 26.09.1996 DE 19639586

(71) Anmelder:
• Carl Zeiss
D-89518 Heidenheim (Brenz) (DE)
Benannte Vertragsstaaten:
DE FR IT NL

• CARL ZEISS-STIFTUNG HANDELND ALS CARL ZEISS
D-89518 Heidenheim (Brenz) (DE)
Benannte Vertragsstaaten:
GB

(72) Erfinder: Schuster, Karl Heinz
89551 Königsbronn (DE)

(54) **Katadioptrisches Mikrolithographie-Reduktionsobjektiv**

(57) Ein katadioptrisches Mikrolithographie-Reduktionsobjektiv mit zwei einander zugewandten Konkavspiegeln (21, 23) mit symmetrischem Aufbau und zentraler Abschattung, bei dem den Spiegeln (21, 23) auf dem Lichtweg zum Bild (61) Linsen (24-60) nachgeordnet sind. Vorzugsweise sind objektseitig Linsen (15-20) in den Zwischenraum zwischen den Spiegeln (21, 23) im Bereich der zentralen Abschattung vorgeschoben. Der Lichtweg zwischen den Konkavspiegeln kann dabei bevorzugt frei von Linsen bleiben. Die Ausbildung eines Zwischenbilds (Z) nach den Spiegeln (21, 23) eröffnet besonders gute Korrektionsmöglichkeiten.

FIG.1

**Beschreibung**

Die Erfindung betrifft ein katadioptrisches Mikrolithographie-Reduktionsobjektiv mit zwei einander zugewandten Konkavspiegeln mit achssymmetrischem Aufbau und zentraler Abschattung.

Katadioptrische Reduktionsobjektive für die DUV-Mikrolithographie sind bekannt: In der Ausführung nach der Patentanmeldung DE 196 16 922.4 und den darin angegebenen Zitaten ist ein diagonal stehender polarisierender Strahlteiler und eine Viertelwellenlängenplatte erforderlich. Beide sind im DUV-Wellenlängenbereich ein herstelltechnisches Problem. Zudem ist eine Umlenkung der optischen Achse um ca. 90° unabdingbar, so daß regelmäßig eine zweite Umlenkung vorgesehen wird, um die Parallelität von Reticle und Wafer zu erhalten.

Andere katadioptrische Systeme sind asymmetrisch aufgebaut, z.B. vom Dyson-Typ oder nach EP 0 581 585 und darin angegebenen Zitaten.

Aus der US 5,488,229 ist ein gattungsgemäßes katadioptrisches Mikrolithographie-Reduktionsobjektiv bekannt, das achssymmetrisch aufgebaut ist und zwei einander zugekehrte Konkavspiegel aufweist. Prinzipiell ist eine zentrale Abschattung gegeben, die jedoch in Anbetracht der immer größeren Bedeutung von Ringaperturbeleuchtungen kein Problem darstellt.

Beide Konkavspiegel sind als Manginspiegel ausgeführt, der zweite wirkt in seinem mittigen Bereich als Linse. Nachfolgend sind nur noch die Iris-Blende und der Wafer angeordnet. Das Beispiel kommt bei $\beta = 0,1$, NA = 0,6, Lambda = 193 nm mit fünf Linsen und zwei Mangin-Spiegeln aus. Allerdings ist zur Bildfeldgröße und zur Größe der mittigen Abschattung nichts ausgesagt. Bei Bildfeldgrößen, wie sie mit der Erfindung erreicht werden, wären Manginspiegel mit Durchmessern bis zu einem Meter erforderlich. Es ist nicht absehbar, daß Quarzglas oder gar ein anderer Linsenwerkstoff in diesen Abmessungen in der für die DUV-Mikrolithographie unverzichtbaren Qualität bereitgestellt werden kann.

US 5,031,976 gibt einen ähnlichen Aufbau an. Der zweite Spiegel ist jedoch plan und zwischen den Spiegeln ist eine separate dicke Linse vorgesehen.

Aufgabe der Erfindung ist die Bereitstellung eines gattungsgemäßen Reduktionsobjektivs mit einem Bildfeld, dessen Größe den Produktionsanforderungen von Wafer Steppern entspricht, und mit einer geeigneten Fehlerkorrektur. Dabei soll eine produktionstechnisch gangbare Konstruktion angegeben werden, die besonders große und dicke Linsen vermeidet.

Die Lösung findet sich mit einem Reduktionsobjektiv nach Anspruch 1, dessen Kennzeichen es ist, daß den Spiegeln auf dem Lichtweg zum Bild Linsen nachgeordnet sind. Hier ist das Lichtbündel wieder auf einen Durchmesser reduziert, der erheblich kleiner als die Spiegeldurchmesser ist, so daß Korrekturlinsen mit mäßigen Durchmessern eingesetzt werden können.

Vorteilhaft ist es gemäß Anspruch 2, wenn das objektseitige Linsensystem in den Spiegelzwischenraum im Bereich der zentralen Abschattung hineinragt. Damit werden die Farbfehler positiv beeinflußt.

Ist der Lichtweg zwischen den Spiegeln, also im Bereich des größten Lichtbündeldurchmessers, frei von Linsen gemäß Anspruch 3, so ist insbesondere das Ziel, kleine Linsen zu benutzen, erreicht.

Mit einem Zwischenbild nach den Spiegeln gemäß Anspruch 4, ergeben sich im Raum zwischen Zwischenbild und Bild zu den Spiegeln konjugierte Flächen, in deren Nähe optimal Elemente zur Korrektur der von den Spiegeln verursachten Bildfehler angeordnet werden können. Geeignet hierzu ist ein Meniskenpaar.

Die Ausbildung nach Anspruch 5 betrifft ein Korrekturelement, nämlich eine zwischen zwei Linsen eingeschlossene konvexe Luftlinse, mit der gute Astigmatismuskorrektion erreicht werden kann.

Die Ansprüche 6-9 geben die erreichte vorteilhafte Qualität mit großem Bildfeld bei großer numerischer Apertur, geringer Bildfeldkrümmung und ausreichender chromatischer Bandbreite an.

Näher erläutert wird die Erfindung anhand der Zeichnung.

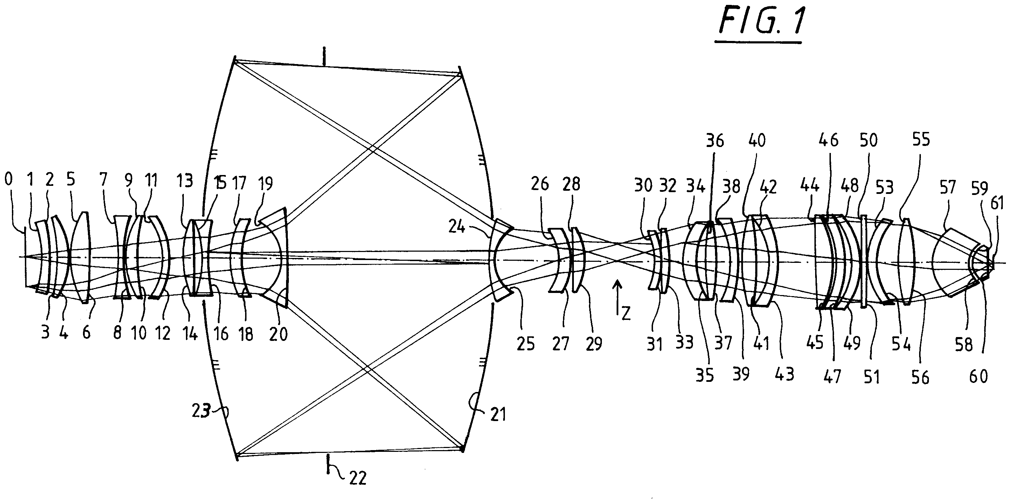

Figur 1      zeigt den Linsenschnitt eines bevorzugten Ausführungsbeispiels.

Der Linsenschnitt der Figur 1 mit den Daten der Tabelle 1 gibt das bevorzugte Ausführungsbeispiel an. Hier sind insgesamt 27 Linsen und zwei Spiegel 21, 23, sowie eine Planplatte 50/51 vorgesehen. Bei einem Bildfelddurchmesser von 27 mm beträgt der Durchmesser der größten Linse 19/20 ca. 173 mm, der Durchmesser des größten Spiegels 23 beträgt ca. 707 mm. Die zentrale Abschattung beträgt ca. 35 % des Spiegeldurchmessers. Ausgelegt ist das Objektiv für die Wellenlänge 193,38 nm. die bildseitige numerische Apertur ist 0,70.

Eine Zwischenbildebene Z ist zwischen den Flächen 29 und 30 realisiert und an der dementsprechenden zusätzlichen Pupille P sind die Menisken 46, 47; 48, 49 und 53, 54 vorgesehen, welche von den Spiegeln 21, 23 erzeugte Bildfehler, insbesondere außeraxiale, hier optimal korrigieren können.

Zwischen den Menisken, unmittelbar im Bereich der Pupille p, ist eine Planplatte 50, 51 vorgesehen. In der Herstellung dieser Objektive kann diese Planplatte 50, 51 dazu benutzt werden, Restfehler des Objektiv-Exemplars durch kleine Formkorrekturen, welche zum Beispiel durch Ionenstrahlätzen erzeugt werden können, zu korrigieren.

Die objektseitige Linsengruppe 1-20 ist vom Typ eines Weitwinkel-Retrofokusobjektivs, dazu gespiegelt ist auch die Linsengruppe 25-33 vor dem Zwischenbild von diesem Typ. Die bei beiden spiegelseitigen zerstreuenden Menisken 19, 20 und 24, 25 machen die Lichtbündel spiegelseitig stark divergent und ergeben so die geringe zentrale Abschattung. Die beiden Linsengruppen 1-20 und 24-33 tauchen so in die Spiegelanordnung 21, 23 ein. Wichtig ist auch die Funktion der Menisken 19, 20 und 24, 25, einen großen Farblängsfehler vorzuhalten. Dieser wird von den gesamten restlichen Linsen wieder kompensiert.

Die stark konvexe Fläche 57 in Verbindung mit der weitgehenden Glasfüllung des Raums bis zum Objekt 60 ist für die vorliegende Objektivklasse signifikant und ähnlich bei Mikroskopobjektiven üblich.

Alle Linsen sind sphärisch und aus Quarzglas gefertigt. Für den Betrieb mit niedrigeren Wellenlängen (z.B. 157 nm) können auch andere Werkstoffe (Kalziumfluorid) vorgesehen werden.

Die Spiegel sind asphärisch nach der bekannten Potenzreihenentwicklung $P(h) = (1/2R) h^2 + c_1 h^4 + ... + c_n h^{2n}$ für die Pfeilhöhe P als Funktion des Radius h (Höhe zur optischen Achse) mit den in der Tabelle 1 angegebenen asphärischen Konstanten $c_1$ bis $c_n$. R ist der Scheitelradius aus der Tabelle 1. Die Abweichungen zur Sphäre sind moderat und fertigungstechnisch beherrschbar.

Die Herstellung derartiger asphärischer Spiegel im Durchmesserbereich um einen halben bis zu einem Meter ist aus dem Bereich der astronomischen Instrumente bekannt. Zur Serienfertigung können auch Abformtechniken, z.B. die Galvanoplastik, herangezogen werden. Die Fertigungsgenauigkeit kann beschränkt bleiben, da konjugierte Korrekturflächen auf der obenerwähnten Planplatte 50/51 oder auf einer der benachbarten Meniskenflächen 52 usw. zur Verfügung stehen.

Auch ist es möglich, elastische Spiegel vorzusehen. Einmal können diese in Abwandlung des bekannten Richtkittens mit Aktuatoren in einer Montagephase einjustiert und dann an einem starren Träger fixiert werden. Andererseits können diese auch im Betrieb on-line mit z.B. piezoelektrischen Aktuatoren in optimale Form geregelt werden, um z.B. thermische Linseneffekte auszugleichen.

# TABELLE 1

| FL | RADIEN | DICKEN | GLAESER |
|---|---|---|---|
| 0 | Objekt | | |
| 1 | -152.31391 | 9.3670 | SUPRA1 |
| 2 | -934.28326 | 17.0479 | |
| 3 | -258.50662 | 17.9979 | SUPRA1 |
| 4 | -144.13579 | 1.5242 | |
| 5 | 154.21865 | 34.9172 | SUPRA1 |
| 6 | -1044.16454 | 50.7402 | |
| 7 | -368.80081 | 10.1606 | SUPRA1 |
| 8 | 238.39923 | 2.8591 | |
| 9 | 138.64466 | 18.7404 | SUPRA1 |
| 10 | 312.00878 | 44.3518 | |
| 11 | -122.26492 | 12.8011 | SUPRA1 |
| 12 | -126.81758 | 23.6934 | |
| 13 | 177.47680 | 19.3377 | SUPRA1 |
| 14 | 11788.39412 | 15.9136 | |
| 15 | -172.90112 | 7.5815 | SUPRA1 |
| 16 | 295.02570 | 40.3349 | |
| 17 | 149.52872 | 16.3659 | SUPRA1 |
| 18 | 134.69462 | 72.7792 | |
| 19 | -79.93868 | 10.3887 | SUPRA1 |
| 20 | -1129.04446 | 361.0000 | |
| 21 | -981.42317 AS | -295.0000 | |
| 22 | UNENDL | -215.0000 | |
| | BLENDE | .0000 | |
| 23 | 1113.03904 AS | 500.6296 | |
| 24 | 226.60310 | 8.2622 | SUPRA1 |
| 25 | 68.17289 | 114.8808 | |
| 26 | -91.66030 | 20.9850 | SUPRA1 |
| 27 | -111.26948 | 4.2440 | |
| 28 | -1008.42184 | 16.6387 | SUPRA1 |
| 29 | -119.24333 | 127.0374 | |
| 30 | -105.29899 | 8.7290 | SUPRA1 |
| 31 | -151.29067 | .0532 | |
| 32 | 6408.14692 | 13.0429 | SUPRA1 |
| 33 | -304.40400 | 26.5391 | |
| 34 | 115.05002 | 19.9112 | SUPRA1 |
| 35 | 113.02003 | 18.2856 | |
| 36 | 480.50139 | 16.6611 | SUPRA1 |
| 37 | -425.21265 | 25.4688 | |
| 38 | -154.46333 | 14.1991 | SUPRA1 |
| 39 | -240.64362 | 8.7927 | |
| 40 | 289.04838 | 24.5556 | SUPRA1 |
| 41 | -469.53160 | 22.0894 | |
| 42 | -127.91442 | 14.2424 | SUPRA1 |
| 43 | -179.26273 | 67.4834 | |
| 44 | 4904.05552 | 29.6764 | SUPRA1 |
| 45 | -179.72857 | 8.1164 | |
| 46 | -152.96898 | 13.7764 | SUPRA1 |
| 47 | -203.54702 | 12.9619 | |
| 48 | -127.62811 | 14.1864 | SUPRA1 |
| 49 | -139.16594 | .4118 | |
| 50 | UNENDL | 8.0000 | SUPRA1 |
| 51 | UNENDL | 4.0000 | |
| 52 | UNENDL | .0001 | |
| 53 | 121.70233 | 15.3662 | SUPRA1 |
| 54 | 109.92284 | 36.1371 | |
| 55 | 219.24113 | 30.1687 | SUPRA1 |
| 56 | -303.41760 | 31.5237 | |
| 57 | 73.58279 | 65.3446 | SUPRA1 |
| 58 | 43.81552 | 3.1551 | |
| 59 | 41.37557 | 28.5961 | SUPRA1 |
| 60 | 604.77330 | .6625 | |
| 61 | UNENDL | | |

ASPHAERE AN FLAECHE  21

C 1 = -.1984860500E-10
C 2 = -.8471592100E-16
C 3 = -.1338734300E-21
C 4 = .1383973100E-27
C 5 = .1716228700E-32
C 6 = .4845464500E-38
C 7 = -.3305365300E-44

ASPHAERE AN FLAECHE  23

C 1 = .1686460500E-10
C 2 = -.4430448700E-16
C 3 = -.1503908600E-21
C 4 = .2530123600E-27
C 5 = -.7105016500E-35
C 6 = -.2345880200E-38
C 7 = .3712453500E-43

SUPRA1 = Quarzglas

**Patentansprüche**

1. Katadioptrisches Mikrolithographie-Reduktionsobjektiv mit zwei einander zugewandten Konkavspiegeln (21, 23) mit symmetrischem Aufbau und zentraler Abschattung, dadurch gekennzeichnet, daß den Spiegeln (21, 23) auf dem Lichtweg zum Bild (61) Linsen (24-60) nachgeordnet sind.

2. Reduktionsobjektiv nach Anspruch 1, dadurch gekennzeichnet, daß objektseitig Linsen (15-20) in den Zwischenraum zwischen den Spiegeln (21, 23) im Bereich der zentralen Abschattung vorgeschoben sind.

3. Reduktionsobjektiv nach Anspruch 1 oder Anspruch 2, dadurch gekennzeichnet, daß der Lichtweg zwischen den Konkavspiegeln (21, 23) frei von Linsen ist.

4. Reduktionsobjektiv nach mindestens einem der Ansprüche 1-3, dadurch gekennzeichnet, daß nach den Spiegeln (21, 23) ein Zwischenbild (Z) vorhanden ist.

5. Reduktionsobjektiv nach Anspruch 4, dadurch gekennzeichnet, daß zwei Linsen (34, 35 und 36, 37; 40, 41 und 42, 43) nach dem Zwischenbild (Z) eine konvexe Luftlinse einschließen.

6. Reduktionsobjektiv nach mindestens einem der Ansprüche 1-5, dadurch gekennzeichnet, daß das Bildfeld größer als 20 mm im Durchmesser ist.

7. Reduktionsobjektiv nach mindestens einem der Ansprüche 1-5, dadurch gekennzeichnet, daß die bildseitige numerische Apertur größer als 0,60 ist.

8. Reduktionsobjektiv nach mindestens einem der Ansprüche 1-7, dadurch gekennzeichnet, daß die Bildfeldwölbung kleiner als 0,06 $\mu$m ist.

9. Reduktionsobjektiv nach mindestens einem der Ansprüche 1-8, dadurch gekennzeichnet, daß die chromatische Korrektur für eine Bandbreite von mindestens 6 pm erreicht wird.

10. Reduktionsobjektiv nach mindestens einem der Ansprüche 1-9, dadurch gekennzeichnet, daß im Bereich der auf das Zwischenbild (Z) folgenden Pupille (P) zur Pupille konvexe Menisken (48, 49; 53, 54) angeordnet sind.

11. Reduktionsobjektiv nach mindestens einem der Ansprüche 1-10, dadurch gekennzeichnet, daß im Bereich der auf das Zwischenbild (Z) folgenden Pupille (P) ein optisches Element (50, 51) angeordnet ist, das nicht sphärische Korrekturflächen aufweist.

_FIG.1_

EP 0 833 180 A2